Europäisches Patentamt

European Patent Office

Office européen des brevets

(11) Veröffentlichungsnummer: **0 260 471**
A1

## (12) EUROPÄISCHE PATENTANMELDUNG

(21) Anmeldenummer: 87112123.2

(22) Anmeldetag: 21.08.87

(51) Int. Cl.⁴ **H01L 29/74**, H01L 29/72, H01L 29/52, H01L 29/54, H01L 23/48, H01L 25/08, H01L 29/06

(30) Priorität: 16.09.86 CH 3707/86

(43) Veröffentlichungstag der Anmeldung:
23.03.88 Patentblatt 88/12

(84) Benannte Vertragsstaaten:
CH DE FR GB IT LI SE

(71) Anmelder: BBC Brown Boveri AG

CH-5401 Baden(CH)

(72) Erfinder: Broich, Bruno, Dr.
Pilgerstrasse 83
CH-5405 Baden(CH)
Erfinder: Grüning, Horst, Dr.
Im Ergel 10
CH-5404 Baden(CH)

(54) Leistungs-Halbleiterbauelement.

(57) Bei einem Leistungs-Halbleiterbauelement mit sogenannter "recessed-gate"-Struktur auf der Kathodenseite wird die aus Kathodenfingern (1) und einer tieferliegenden Gateebene (2) bestehende grossflächige Steuerstruktur in eine Vielzahl kleinflächiger Steuerzonen (25a, 25b) aufgeteilt, die jeweils für sich mit einem Kathodenstempel (13a, 13b) verlötet werden.

Hierdurch werden Bauelemente hoher Leistung geschaffen, ohne dass bei Belastungszyklen übermässige thermische Verspannungen auftreten können.

EP 0 260 471 A1

Fig.3

## Leistungs-Halbleiterbauelement

### Technisches Gebiet

Die Erfindung bezieht sich auf Leistungs-Halbleiterbauelemente. Sie betrifft insbesondere derartige Bauelemente mit einer Mehrzahl unterschiedlich dotierter Schichten, welche in einem Halbleitersubstrat zwischen einer Anode und einer Kathode angeordnet sind, kathodenseitig einer Mehrzahl von schmalen Kathodenfingern, welche Kathodenfinger von einer tieferliegenden Gateebene abgesetzt sind, wobei die Kathodenfinger und die sie umgebende Gateebene eine grossflächige, stufenartige Steuerstruktur bilden.

### Stand der Technik

Beim Einbau leistungsstarker und grossflächiger Halbleiterbauelemente, die in Form von Halbleiterscheiben oder -tabletten vorliegen, in entsprechende Gehäuse sind bezüglich der elektrischen und thermischen Kontaktierung verschiedenartige Probleme zu lösen, die zu unterschiedlichen Befestigungsarten für die Bauelemente geführt haben.

So ist es seit langem bekannt, grossflächige Leistungs-Halbleiterbauelemente mit einer vergleichsweise einfachen Struktur (z.B. Dioden) auf beiden Seiten der Halbleiterscheibe mit metallischen Platten zu verlöten, die dem Halbleitermaterial (meist Si) in der thermischen Ausdehnung angepasst sind. Die metallischen Platten bestehen bei Silizium-Halbleitern meist aus Mo oder W (siehe beispielsweise die DE-OS 19 49 731).

Technologisch schwieriger ist die Kontaktierung von abschaltbaren Thyristoren (GTO = Gate Turn Off), die auf der Kathodenseite eine fein unterteilte Steuerstruktur aufweisen, welche aus sich abwechselnden, fingerartigen Kathodenbereichen und dazwischenliegenden Gatebereichen bestehen.

Bei solchen GTO-Bauelementen ist es nun Stand der Technik (siehe z.B. die DE-OS 31 34 074), die Thyristorscheibe anodenseitig wie gehabt mit einer metallischen Kontaktplatte zu verlöten. Zur Kontaktierung der kathodenseitigen Steuerstruktur wird hier ein flächenhafter Druckkontakt verwendet, der gleichzeitig auf die metallisierten Oberflächen der Kathoden-und Gatebereiche gepresst wird und so die thermische und elektrische Verbindung zum Halbleitersubstrat herstellt.

Es ist weiterhin auch Stand der Technik, bei GTOs den sogenannten direkten Druckkontakt einzusetzen (siehe z.B. die US-PS 4,243,999), bei dem die Thyristorscheibe sowohl kathoden-als auch anodenseitig mittels eines Druckkontaktes kontaktiert wird.

Die zuletzt beschriebene Art der Druckkontaktierung stösst jedoch bei Leistungs-Halbleiterbauelementen mit sogenannter "recessed gate"-Struktur auf grosse praktische Schwierigkeiten, da bei diesen Bauelementen (GTO oder FCTh = Field Controlled Thyristor) die kathodenseitige Steuerstruktur aus einer Vielzahl sehr schmaler, länglicher Kathodenfinger besteht, die aus einer sie umgebenden, wesentlich tiefer liegenden Gateebene herausragen (EP-A1 0 121 068). Es wäre deshalb wünschenswert, diese Bauelemente kathodenseitig mit einem Lötkontakt auszustatten.

Die bekannten Konzepte zum Löten von grossflächigen Bauelementen - mit einem Durchmesser grösser gleich 4 mm - zielen, wie bereits erwähnt, darauf ab, durch geeignete Wahl der Kontaktierungsmaterialien (W, Mo) möglichst geringe Unterschiede zwischen den verschiedenen Wärmeausdehnungskoeffizienten zu erreichen, um thermische Verspannungen klein zu halten. Auf die "recessed gate"-Bauelemente mit ihren extrem feinen Strukturen können diese Konzepte jedoch nicht übertragen werden, da diese Bauelemente in vielerlei Hinsicht wesentlich empfindlicher sind.

### Darstellung der Erfindung

Es ist nun Aufgabe der Erfindung, Leistungs-Halbleiterbauelemente mit fein unterteilter Steuerstruktur zu schaffen, die einfach und sicher, insbesondere auf der Seite der Steuerstruktur, kontaktiert werden können.

Die Aufgabe wird bei einem Leistungs-Halbleiterbauelement der eingangs genannten Art dadurch gelöst, dass die Steuerstruktur in mehrere, voneinander räumlich getrennte, kleinflächige Steuerzonen aufgeteilt ist, und jede der Steuerzonen mit einem eigenen, auf die Kathodenfinger der jeweiligen Steuerzone aufgebrachten Kathodenstempel versehen ist.

Der Kern der Erfindung besteht also darin, bei grossflächigen Leistungs-Halbleiterbauelementen mit fein unter teilter, grossflächiger Steuerstruktur die Lötprobleme durch eine Aufteilung der Steuerstruktur in kleinere Steuerzonen zu lösen, die dann in herkömmlicher Weise getrennt für sich gelötet werden können. Damit zerfällt das Bauelement von der Funktion her in eine Vielzahl kleinerer Teilelemente, die jedoch alle in einem gemeinsamen Halbleitersubstrat untergebracht sind und die anodenseitigen Schichten gemeinsam haben.

Gemäss einem bevorzugten Ausführungsbeispiel der Erfindung wird die Unterteilung der Steuerstruktur so vorgenommen, dass Teilelemente mit einer maximalen Strombelastbarkeit kleiner gleich 10 A entstehen.

Vorteilhaft ist es, die Kathodenstempel für die einzelnen Steuerzonen zum Zwecke der elektrischen Gegenkopplung aus einem Widerstandsmaterial, insbesondere MoSi, zu wählen.

Handelt es sich bei dem Leistungs-Halbleiterbauelement um einen FCTh, kann nach der Erfindung in besonders günstiger Weise eine Kaskodeschaltung aus dem FCTh und einem MOSFET (Metal Oxide Semiconductor Field Effect Transistor) realisiert werden, indem als Kathodenstempel MOSFET-Elemente kleiner Leistung auf den Kathodenfingern der einzelnen Steuerzonen angebracht sind, wobei die Grösse der MOSFET-Elemente der Grösse der Steuerzonen entspricht und die MOSFET-Elemente zusammen mit den durch die Steuerzonen gebildeten Teilelementen des FCTh die Thyristor-MOSFET-Kaskode bilden.

Weitere Ausführungsbeispiele ergeben sich aus den Unteransprüchen.

## Kurze Beschreibung der Zeichnung

Die Erfindung soll nun nachfolgend anhand von Ausführungsbeispielen im Zusammenhang mit der Zeichnung beschrieben und näher erläutert werden. Es zeigen:

Fig. 1A in perspektivischer Ansicht ein Leistungs-Halbleiterbauelement mit fein unterteilter kathodenseitiger Steuerstruktur, wie es bei der Erfindung Verwendung findet;

Fig. 1B den Schichtaufbau eines Bauelements nach Fig. 1A für den Fall des GTO (im Ausschnitt);

Fig. 1C den entsprechenden Schichtaufbau für den Fall des FCTh;

Fig. 2 einen herkömmlichen kathodenseitigen Lötkontakt;

Fig. 3 ein Beispiel für einen Lötkontakt nach der Erfindung;

Fig. 4 ein bevorzugtes Ausführungsbeispiel des erfindungsgemässen Bauelements mit lokaler Dickenreduktion des Substrats;

Fig. 5A das Schaltbild einer FCTh-MOSFET-Kaskode;

Fig. 5B die Steuerzone eines erfindungsgemässen Bauelements mit direkt aufgebrachtem MOSFET-Element zur Realisierung der Kaskodeschaltung nach Fig. 5A; und

Fig. 5C die Draufsicht auf die hybride Realisierung der Schaltung nach Fig. 5A mit einem Leistungs-Halbleiterbauelement nach der Erfindung.

## Wege zur Ausführung der Erfindung

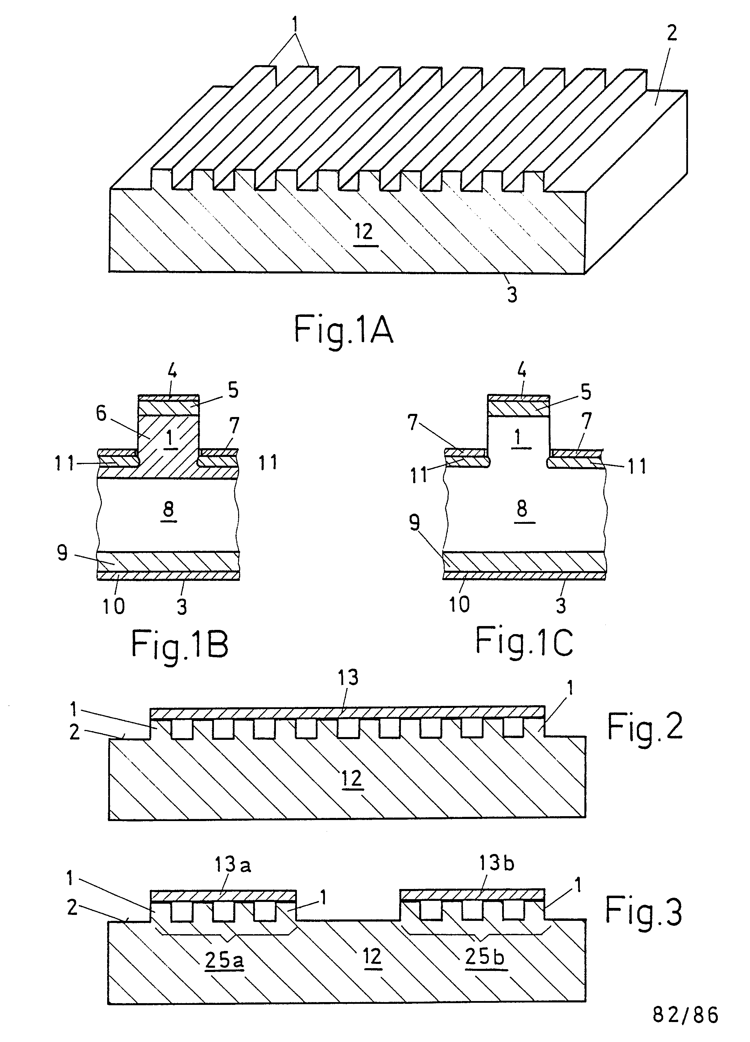

In Fig. 1A ist in perspektivischer Ansicht ein Leistungs-Halbleiterbauelement mit der sogenannten "recessed gate"-Struktur dargestellt. Ein Halbleitersubstrat 12 mit einer im wesentlichen planen Anodenseite 3 weist auf der gegenüberliegenden Kathodenseite eine grossflächige Steuerstruktur auf, die aus einer Vielzahl schmaler, länglicher Kathodenfinger 1 bésteht, die aus einer tieferliegenden, die Kathodenfinger 1 umgebenden Gateebene 2 herausragen. Die tatsächlichen geometrischen Abmessungen der Kathodenfinger 1 und der zwischen ihnen gebildeten Gräben können in allen Einzelheiten z.B. der bereits zitierten EP-A1 0 121 068 entnommen werden.

Der innere Schichtenaufbau des Bauelements nach Fig. 1A gestaltet sich unterschiedlich, je nachdem, ob es sich bei dem Bauelement um einen GTO-Thyristor oder einen FCTh handelt.

Bei GTO-Thyristor (Fig. 1B) ist von der Anodenseite 3 ausgehend zunächst eine p-dotierte Anodenschicht 9 vorhanden, auf die zur Kathodenseite hin nacheinander eine n-Basisschicht 8, eine p-Basisschicht 7 und, im oberen Bereich der Kathodenfinger 1, eine n-dotierte Kathodenschicht 5 folgen. In die Böden der zwischen den Kathodenfingern 1 gebildeten Gräben ist jeweils eine $p^+$-dotierte Gatezone 11 eingelassen, die auf der Oberseite entsprechende metallisierte Gatekontakte 7 trägt. In vergleichbarer Weise sind auf der Anodenseite 3 ein Anodenkontakt 10 und auf den Kathodenfingern 1 Kathodenkontakte 4 angebracht. Die ganze Anordnung bildet die aus der Thyristortechnik bekannte Vierschicht-Struktur, wobei allerdings die kathodenseitige Steuerstruktur in sehr spezieller Weise ausgebildet ist.

Beim FCTh (Fig. 1C) fehlt eine p-Basisschicht. Hier bildet die n-Basisschicht 8 eine in die Kathodenfinger 1 hineinragende n-Kanalzone, die beim Anlegen einer geeigneten Steuerspannung an die Gatekontakte 7 abgeschnürt werden kann.

Für beide Bauelement-Konfigurationen (GTO und FCTh) können Schichtdicken und Dotierungskonzentrationen ebenfalls der EP-A1 0 121 068 entnommen werden.

Würde nun das Bauelement gemäss Fig. 1A in herkömmlicher Weise ausgeführt und kathodenseitig durch Löten kontaktiert, ergäbe sich eine Anordnung wie die in Fig. 2 gezeigte: Auf die Kathodenfinger 1 des Halbleitersubstrats 12 ist ein einstückiger, durchgehender Kathodenstempel 13 gelötet. Aus der Figur ist unmittelbar ersichtlich, dass bei grossflächigen Steuerstrukturen (Durchmesser grösser gleich 4 mm) und den nicht zu vernachlässigenden Unterschieden in den Ausdehnungskoeffizienten von Substratmaterial (Si) und Stempelmaterial (Mo oder W) bei thermischen Zyklen Verspannungen auftreten, welche die - schmalen Kathodenfinger 1 mechanisch besonders stark belasten.

Um dies zu umgehen, wird nach der Erfindung, wie im Beispiel der Fig. 3 dargestellt, die gesamte, grossflächige Steuerstruktur in eine Vielzahl von kleinflächigen Steuerzonen 25a, 25b aufgeteilt, d.h., jeweils eine bestimmte Anzahl von Kathodenfingern 1 zu Gruppen zusammengefasst.

Die voneinander durch einen breiteren Gatebereich von vorzugsweise etwa 1 mm getrennten Steuerzonen 25a, 25b werden auf der Oberseite ihrer Kathodenfinger 1 in herkömmlicher Löttechnik mit entsprechenden einzelnen Kathodenstempeln 13a, 13b verbunden, so dass innerhalb des Halbleitersubstrats 12 des Gesamt-Bauelements entsprechend den Steuerzonen 25a, 25b kleinflächige Teilelemente entstehen, bei denen die gefürchteten thermischen Verspannungen durch die aufgelöteten Kathodenstempel 13a, 13b in ihrer Grösse auf ein unschädliches Mass begrenzt sind.

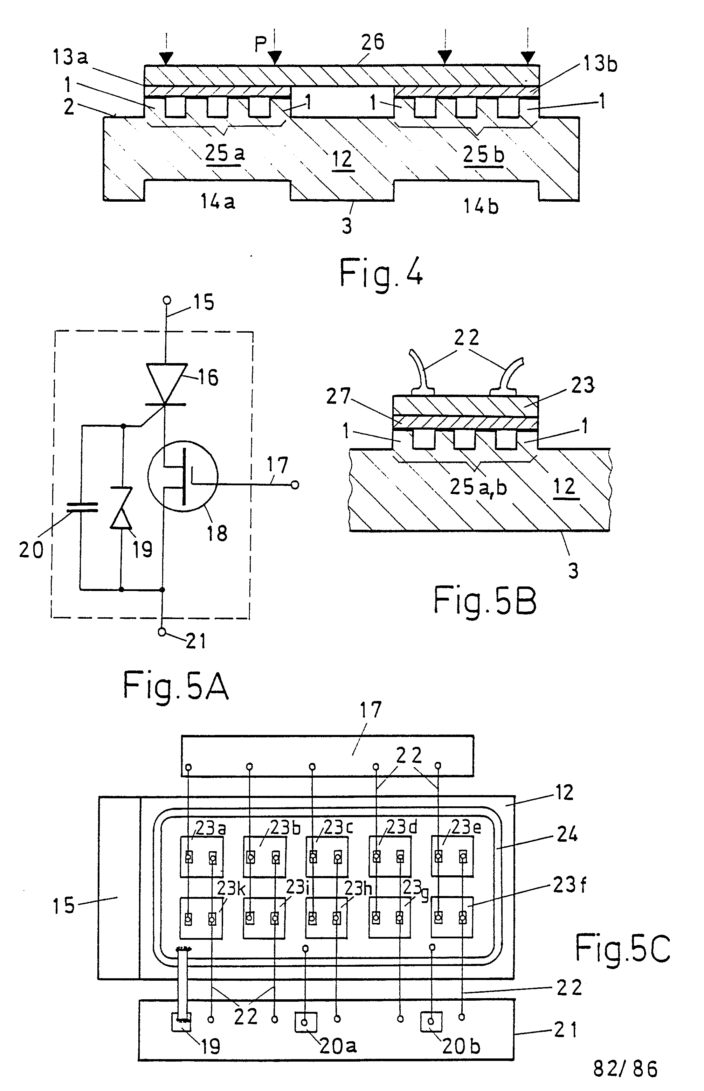

Die einzelnen Teilelemente können nach dem Auflöten der Kathodenstempel 13a, 13b untereinander elektrisch durch herkömmliches Drahtbonden oder - wie in Fig. 4 durch einen Druckkontakt 26 angedeutet - durch Druckkontaktierung verbunden werden.

Bevorzugt wird die Unterteilung der Steuerstruktur in die einzelnen Steuerzonen 25a, 25b in der Weise vorgenommen, dass Teilelemente mit einer Strombelastbarkeit von kleiner gleich 10 A entstehen. Dies entspricht geometrischen Abmessungen der zugehörigen Steuerzonen, die bezüglich der thermischen Verspannung unkritisch sind. Bei der Ausführung des Bauelements als FCTh haben die einzelnen Steuerzonen bzw. Teilelemente bei dieser Dimensionierung eine Fläche von etwa 3 $\times$ 3 mm$^2$ oder kleiner.

Die erfindungsgemässe Aufteilung der Steuerstruktur in eine Vielzahl kleiner Steuerzonen gemäss Fig. 3 ermöglicht eine weitere vorteilhafte Ausgestaltung des Bauelements, wie sie in Fig. 4 dargestellt ist. Die durch die räumliche Trennung der Steuerzonen 25a, 25b entstehenden Teilelemente können in ihren elektrischen Eigenschaften, insbesondere im Durchlassverhalten, dadurch optimiert werden, dass im aktiven Bereich die Dicke des Halbleitersubstrats 12 deutlich reduziert wird.

Bei grossflächigen Bauelementen ist dies nicht ohne weiteres möglich, weil eine grossflächige Reduzierung der Substratdicke das Substrat mechanisch zu empfindlich werden lässt. Im vorliegenden Fall reicht es wegen der räumlich getrennten Teilelemente jedoch aus, dass Halbleitersubstrat 12 lokal, d.h. nur in den Bereichen der jeweiligen Teilelemente, durch entsprechende, von der Anodenseite 3 her eingebrachte, tiefe Aetzgruben 14a, 14b in der Dicke zu reduzieren. Zwischen den Aetzgruben 14a, 14b bleiben dann Stege mit der ursprünglichen Dicke erhalten, die eine unveränderte mechanische Festigkeit gewährleisten.

Wie bereits erwähnt, kann in einer Variante des erfindungsgemässen Bauelements die elektrische Verbindung der Teilelemente über die Kathodenstempel 13a, 13b mittels des in Fig. 4 gezeigten Druckkontaktes 26 erfolgen, der in Pfeilrichtung mit einem ausreichenden Anpressdruck P auf das Halbleitersubstrat 12 gepresst wird.

Weiterhin ist es vorteilhaft, die Kathodenstempel 13a, 13b aus einem geeigneten Widerstandsmaterial, insbesondere MoSi, auszuführen. Auf diese Weise erhält man eine integrierte elektrische Gegenkopplung der einzelnen Teilelemente, die eine gleichmässige Lastverteilung und das Unterbinden eines thermischen Weglaufens zur Folge hat. Ein in dieser Weise gegengekoppelter FCTh weist die folgenden Daten auf:

-Spannungsabfall an der Gegenkopplung bei Vollast: 0,2 V

-Unterteilung in 10 A-Teilelemente zu je 3 $\times$ 3 mm$^2$ Fläche

-Durchlasswiderstand des Teilelementwiderstandes: 20 m$\Omega$

Die erfindungsgemässe Unterteilung der Steuerstruktur des Leistungs-halbleiterbauelements in eine Vielzahl von getrennten Steuerzonen ermöglicht schliesslich die besonders vorteilhafte Realisierung einer sogenannten, an sich bekannten, Kaskodeschaltung aus einem FCTh und einem Leistungs-MOSFET. Das entsprechende Prinzipschaltbild ist in der Fig. 5A wiedergegeben.

Die gesamte, durch die gestrichelte Umrahmung gekennzeichnete Einheit enthält zwischen einem Anodenanschluss 15 und einem Kathodenanschluss 21 die Serienschaltung eines FCTh 16 und eines MOSFET 18. Das Gate des FCTh 16 ist über eine Parallelschaltung aus einem Kondensator 20 und einer Zenerdiode 19 mit dem Kathodenanschluss 21 verbunden. Das Gate des MOSFET 18 ist als Gateanschluss 17 nach aussen geführt. Die beschriebene Kaskodeschaltung zeichnet sich durch besonders günstige Schalteigenschaften aus.

In den bisherigen Kaskodeschaltungs-Konzepten wurde eine Serienschaltung zweier Einzelelemente (FCTh und MOSFET) vorgesehen, die z.B. räumlich nebeneinander angeordnet und durch Bonddrähte kontaktiert waren. Dieser Aufbau bedingt jedoch hohe Anforderungen an die Homogenität der Bauelemente, wenn Ströme oberhalb 50 A bei 1 kV geschaltet werden sollen. Im übrigen ist die Herstellung entsprechend grosser, leistungsstarker MOSFETs erheblich aufwendiger, als die Herstellung kleinerer Elemente.

Eine Lösung dieser Probleme lässt sich nun mit dem erfindungsgemässen Leistungs-Halbleiterbauelement in Form des FCTh erreichen. Dies geschieht dahingehend, dass als Kathodenstempel für die Steuerzonen kleine MOSFET-Elemente 23 auf die gruppenweise in den Steuerzonen 23a, b angeordneten Kathodenfinger 1 entweder direkt gelötet werden oder wie in Fig. 5B dargestellt, auf einen Zwischenstempel 27 entsprechender Grösse, der z.B. aus Cu, Mo oder W besteht und seinerseits auf die Kathodenfinger 1 gelötet ist, geklebt sind. Auf diese Weise wird eine direkte elektrische Verbindung zwischen den Teilelementen des FCTh und den MOSFET-Elementen 23 erzielt. Die anderen Anschlüsse am MOSFET-Element werden dann beispielsweise durch gebondete Anschlussdrähte 22 hergestellt.

Jedes Teilelement des FCTh ist hierbei wiederum für einen maximalen Strom von bis zu 10 A ausgelegt und durch einen breiteren Gatebereich von etwa 1 mm von den benachbarten Teilelementen getrennt. Durch eine Maske werden die Gruppen der Kathodenfinger so mit Metall bedampft, dass sie untereinander elektrisch getrennt bleiben. Der FCTh wird mit seiner Anodenseite 3 in herkömmlicher Technik z.B. auf ein Cu-beschichtetes $Al_2O_3$-Substrat gelötet. Die MOSFET-Elemente 23 werden mit den Gruppen von Kathodenfingern 1 z.B. durch das sogenannte "die-bonding" verbunden.

In Fig. 5C ist in Draufsicht eine in dieser Technik aufgebaute, für etwa 100 A ausgelegte, hybride FCTh-MOSFET-Kaskode dargestellt. Auf das nicht gezeigte Keramiksubstrat ist das Halbleitersubstrat 12 mit einem seitlich herausragenden Anodenanschluss 15 aufgelötet. Kathodenseitig sind innerhalb eines ringförmigen Randabschlusses 24 insgesamt 10 getrennte Steuerzonen angeordnet, die FCTh-Teilelemente mit einer Belastbarkeit von jeweils etwa 10 A definieren und durch die darüberliegenden MOSFET-Elemente 23a, ..., 23k verdeckt sind.

Die MOSFET-Elemente 23a, ..., 23k sind mittels Anschlussdrähten 22 aus Al in der sogenannten "multiple stitch"-Technik einerseits mit einer als Gateanschluss 17 dienenden Leiterfläche und andererseits mit einer als Kathodenanschluss 21 dienenden Leiterfläche verbunden. Die Zenerdiode 19 kann in der gezeigten Weise als Einzelelement auf dem Kathodenanschluss 21 montiert werden.

Entsprechendes gilt für den als Einschaltkapazität wirkenden Kondensator (20 in Fig. 5A), der hier zur Erzielung einer verbesserten Stromverteilung in zwei Kondensatoren 20a und 20b aufgeteilt ist.

Die gezeigte, beispielhafte Anordnung der Fig. 5A-C hat eine ganze Reihe von Vorteilen:

-Gegenkopplung der kleinen FCTh-Teilelemente durch die Innenwiderstände der MOSFET-Elemente im ON-Zustand;

-Strombegrenzung durch die Pentodencharakteristik der MOSFET-Elemente bei guter Stromverteilung auf die einzelnen Teilelemente; daraus folgt eine hohe Resistenz gegen eine Fehlschaltung;
-Realisierung von Kaskodeschaltungen nahezu ohne obere Grenze für höchste Ströme möglich;
-Verwendung preiswerter, handelsüblicher MOSFET-Elemente;
-einfacher Aufbau;
-gute Verteilung der Verlustleistung;
-induktivitätsarmer Aufbau (schnelles Schalten);
-Kombination mit lokaler Dickenreduktion durch tiefgeätzte Anode (Fig. 4) möglich, und
-Schutz der Ansteuerelektronik durch hochbelastbare FCTh-Gate-Kontaktierung.

Insgesamt steht mit der Erfindung ein Leistungs-Halbleiterbauelement zur Verfügung, bei dem durch einfache Massnahmen selbst bei sehr hohen Leistungen und damit grossen Substratflächen eine sichere kathodenseitige Kontaktierung ermöglicht wird, und das die Kombination mit anderen, sehr vorteilhaften Massnahmen (tiefgeätzte Anode oder FCTh-MOSFET-Kaskode) ermöglicht und begünstigt.

## Ansprüche

1. Leistungs-Halbleiterbauelement mit

(a) einer Mehrzahl unterschiedlich dotierter Schichten, welche in einem Halbleitersubstrat (12) zwischen einer Anode und einer Kathode angeordnet sind,

(b) kathodenseitig einer Mehrzahl von - schmalen Kathodenfingern (1),

(c) welche Kathodenfinger von einer tieferliegenden Gateebene (2) abgesetzt sind, wobei

(d) die Kathodenfinger (1) und die sie umgebende Gateebene (2) eine grossflächige, stufenartige Steuerstruktur bilden,

dadurch gekennzeichnet, dass

(e) die Steuerstruktur in mehrere, voneinander räumlich getrennte, kleinflächige Steuerzonen (25a, 25b) aufgeteilt ist, und

(f) jede der Steuerzonen (25a, 25b) mit einem eigenen, auf die Kathodenfinger (1) der jeweiligen Steuerzone (25a, 25b) aufgebrachten Kathodenstempel (13a, 13b) versehen ist.

2. Leistungs-Halbleiterbauelement nach Anspruch 1, dadurch gekennzeichnet, dass es die Struktur eines über ein Gate abschaltbaren Thyristors (GTO = Gate Turn Off) aufweist mit einer p-dotierten Anodenschicht (9), einer n-Basisschicht (8), einer p-Basisschicht (6) und einer n-dotierten Kathodenschicht (5).

3. Leistungs-Halbleiterbauelement nach Anspruch 1, dadurch gekennzeichnet, dass es die Struktur eines feldgesteuerten Thyristors (FCTh = Field Controlled T hyristor) aufweist mit einer p-dotierten Anodenschicht (9), einer als Kanalschicht wirkenden n-Basisschicht (8) und einer n-dotierten Kathodenschicht (5).

4. Leistungs-Halbleiterbauelement nach Anspruch 1, dadurch gekennzeichnet, dass die Steuerstruktur eine Fläche mit einem Durchmesser grösser gleich 4 mm aufweist, und die Unterteilung der Steuerstruktur in die einzelnen Steuerzonen (25a, 25b) so vorgenommen wird, dass das Bauelement in Teilelemente mit einer Belastbarkeit kleiner gleich 10 A zerfällt.

5. Leistungs-Halbleiterbauelement nach Anspruch 3, dadurch gekennzeichnet, dass jede der Steuerzonen (25a, 25b) eine Fläche von etwa $3 \times 3$ mm² aufweist.

6. Leistungs-Halbleiterbauelement nach Anspruch 1, dadurch gekennzeichnet, dass die Kathodenstempel (13a, 13b) als elektrische Gegenkopplung für die den Steuerzonen (25a, 25b) zugeordneten Teilelemente aus einem Widerstandsmaterial, insbesondere aus MoSi, bestehen.

7. Leistungs-Halbleiterbauelement nach Anspruch 1, dadurch gekennzeichnet, dass die Kathodenstempel (13a, 13b) der einzelnen Steuerzonen (25a, 25b) durch gebondete Drähte oder einen gemeinsamen Druckkontakt (26) miteinander elektrisch verbunden sind.

8. Leistungs-Halbleiterbauelement nach Anspruch 3, dadurch gekennzeichnet, dass als Kathodenstempel (13a, 13b) MOSFET-Elemente (23, 23a, ..., 23k) kleinerer Leistung auf den Kathodenfingern (1) der einzelnen Steuerzonen (25a, 25b) angebracht sind, wobei die Grösse der MOSFET-Elemente (23, 23a, ..., 23k) der Grösse der Steuerzonen (25a, 25b) entspricht, und dass die MOSFET-Elemente (23, 23a, ..., 23k) zusammen mit den durch die Steuerzonen (25a, 25b) gebildeten Teilelementen des FCTh eine Thyristor-MOSFET-Kaskode bilden.

9. Leistungs-Halbleiterbauelement nach Anspruch 1, dadurch gekennzeichnet, dass zur Verbesserung der Durchlasseigenschaften des Bauelements die Dicke des Halbleitersubstrats (12) lokal durch gegenüber den Steuerzonen (25a, 25b) auf der Anodenseite (3) in das Halbleitersubstrat (12) eingelassene, tiefe Aetzgruben (14a, 14b) reduziert ist.

10. Leistungs-Halbleiterbauelement nach Anspruch 8, dadurch gekennzeichnet, dass die MOSFET-Elemente (23, 23a, ..., 23k) entweder direkt auf die Kathodenfinger (1) der einzelnen Steuerzonen (25a, 25b) gelötet sind oder auf einen gelöteten Zwischenstempel (27), insbesondere aus Cu, Mo oder W, geklebt sind.

Fig.1A

Fig.1B

Fig.1C

Fig.2

Fig.3

Fig. 4

Fig. 5A

Fig. 5B

Fig. 5C

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 064 231 (K.K. TOSHIBA)<br>* Seite 8, Zeile 23 - Seite 13, Zeile 18; Figuren 2,3 * | 1-3,5,7 | H 01 L 29/74<br>H 01 L 29/72 |
| Y<br>A | | 6,9<br>4,8 | H 01 L 29/52<br>H 01 L 29/54<br>H 01 L 23/48 |
| D,A | --- <br>EP-A-0 121 068 (BBC AG BROWN, BOVERI & CIE.)<br>* Insgesamt * | 3 | H 01 L 25/08<br>H 01 L 29/06 |
| Y | ---<br>US-A-4 127 863 (KURATA)<br>* Spalte 4, Zeilen 25-34,51-61; Figuren 3-6 * | 6 | |
| A | | 1-3,7,8<br>,10 | |
| Y | ---<br>EP-A-0 082 419 (SIEMENS AG)<br>* Seite 3, Zeile 20 - Seite 4, Zeile 34; Figur 1 * | 9 | |
| X | ---<br>FR-A-2 077 332 (WESTINGHOUSE ELECTRIC CORP.)<br>* Seite 3, Zeile 31 - Seite 5, Zeile 29; Figuren 1-4 * | 1,2,7 | RECHERCHIERTE SACHGEBIETE (Int. Cl.4)<br><br>H 01 L |
| A | ---<br>DE-A-3 346 833 (TOKYO SHIBAURA DENKI K.K.)<br>* Seite 5, Zeilen 31-34; Figur 5 * | 6 | |
| A | ---<br>EP-A-0 064 613 (TOKYO SHIBAURA DENKI K.K.)<br>* Seite 4, Zeile 37 - Seite 5, Zeile 9; Seite 9, Zeilen 28-32; Figuren 2,3 *<br>---     -/- | 6 | |

Der vorliegende Recherchenbericht wurde für alle Patentansprüche erstellt

| Recherchenort | Abschlußdatum der Recherche | Prüfer |
|---|---|---|
| DEN HAAG | 08-12-1987 | MORVAN D.L.D. |

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| P,A | EP-A-0 222 203 (BBC AG BROWN, BOVERI & CIE.)<br>* Spalte 5, Zeile 1 - Spalte 6, Zeile 4; Figuren 1,3 *<br>----- | 8,10 | |

RECHERCHIERTE SACHGEBIETE (Int. Cl.4)

Der vorliegende Recherchenbericht wurde für alle Patentansprüche erstellt

| Recherchenort | Abschlußdatum der Recherche | Prüfer |
|---|---|---|
| DEN HAAG | 08-12-1987 | MORVAN D.L.D. |

EPO FORM 1503 03.82 (P0403)